# EUROPEAN PATENT SPECIFICATION

(11) **EP 4 325 470 B1**
(45) Date of publication and mention of the grant of the patent: **01.10.2025**
(21) Application number: 22919303.2
(22) Date of filing: 03.08.2022
(51) Int. Cl.: H10H 29/34, H10H 29/49

(54) **LED ARRANGEMENT STRUCTURE**
LED-ANORDNUNGSSTRUKTUR
STRUCTURE D'AGENCEMENT DE DEL

(30) Priority: 05.07.2022 CN 202210792762
(43) Date of publication of application: 21.02.2024
(73) Proprietor: Jiangxi MTC Visual Display Co., Ltd, Nanchang, Jiangxi 330000 (CN)
(72) Inventor: ZHANG, Haibo, Shenzen, Guangdong 518000 (CN); HE, Shengbin, Shenzen, Guangdong 518000 (CN); GU, Wei, Shenzen, Guangdong 518000 (CN)
(74) Representative: Murgitroyd & Company
(86) International application number: PCT/CN2022/110067
(87) International publication number: WO 2024/007401

(56) References cited:
- CN-A- 111 402 751
- CN-A- 111 462 643
- CN-A- 112 684 631
- CN-U- 213 751 735
- US-A1- 2017 170 151
- US-A1- 2021 142 751

## Description

### TECHNICAL FIELD

The present disclosure relates to a field of LED display technology, and more particularly, to LED arrangement structures.

### BACKGROUND

An LED display screen is a planar multimedia display terminal composed of a light-emitting diode dot matrix module or a pixel unit, which has the characteristics of high brightness, wide visual range, long service life, low cost, and the like.

Currently, in the design and production process of an LED display screen, it is generally necessary to perforate a PCB board, or increase the width of the PCB board, or increase the number of layers of the PCB board. However, too many holes on the PCB board can easily increase the defect rate of the PCB board, and increasing the width or the number of layers of the PCB board can greatly increase the material cost, thereby greatly increasing the production cost of the LED display screen. Therefore, the inventors have realized that how to reduce the production cost of the LED display screen has become a technical problem urgently to be solved at present.

For example, in the priort art document US2017/0170151 A1, a display device is disclosed. The display device includes a substrate including a wiring electrode; a plurality of semiconductor light emitting devices electrically connected to the wiring electrode; and an intermediate electrode extending along one direction to be electrically connected to conductive electrodes of adjoining semiconductor light emitting devices, covering the conductive electrodes, and facing the wiring electrode to be electrically connected to the wiring electrode.

### SUMMARY

### Technical problem

In view of the deficiencies of the prior art, the present disclosure provides an LED arrangement structure, which is intended to solve the technical problem of high production cost of an LED display screen in the prior art.

### Technical solution

To solve the above problems, an embodiment of the present invention provides an LED arrangement structure including:
a PCB board;
a plurality of first LEDs and a plurality of second LEDs disposed on the PCB board, the plurality of first LEDs and the plurality of second LEDs are arranged in a first direction and/or a second direction in an array manner;
the plurality of first LEDs form one or more first LED rows in the second direction, the plurality of second LEDs form one or more second LED rows in the second direction, and the plurality of first LEDs and the plurality of second LEDs form a plurality of third LED rows in the first direction;
common-electrode terminals of first LEDs in each of the plurality of first LED rows are electrically connected to each other to form one scanning line; common-electrode terminals of second LEDs in each of the plurality of second LED rows are electrically connected to each other to form one scanning line;
each one of the third LED rows (230) comprises one first LED (201) and a plurality of second LEDs (202), a side of the common-electrode terminal of the one first LED (201) is not adjacent to any of the plurality of second LEDs (202), and a side of the non-common-electrode terminal of the one first LED (201) is adjacent to one of the plurality of second LEDs (202), the non-common-electrode terminals of the one first LED (201) and the plurality of second LEDs (202) are electrically connected to each other to form one data line (40), the scanning lines (30) and the data lines (40) are disposed on different layers in the PCB board (10), and the plurality of second LEDs (202) are adjacent to each other; or
each one of the third LED rows (230) comprises a plurality of first LEDs (201) and one second LED (202), the side of the common-electrode terminal of one of the plurality of first LEDs (201) is not adjacent to the one second LED (202) and any of the remaining first LEDs (201), and a side of the non-common-electrode terminal of the one of the plurality of first LEDs (201) is adjacent to one second LED (202), the common-electrode terminals of the plurality of first LEDs (201) and one second LED (202) are electrically connected to each other to form one data line (40), the scanning lines (30) and the data lines (40) are disposed on different layers in the PCB board (10), and the remaining first LEDs (201) expect for the one of the plurality of first LEDs (201) are adjacent to each other.

Preferably, in the LED arrangement structure, each of the scanning lines is disposed on a surface layer of the PCB board, and each of the data lines is disposed on a bottom layer or an inner layer of the PCB board.

Preferably, in the LED arrangement structure, a plurality of adjacent first LEDs in each of the one or more first LED rows constitute one light-emitting pixel.

More preferably, in the LED arrangement structure, the plurality of adjacent first LEDs in each of the one or more first LED rows are sequentially arranged in the second direction to constitute the one light-emitting pixel.

Preferably, in the LED arrangement structure, a plurality of adjacent second LEDs in each of the one or more second LED rows constitute one light-emitting pixel.

More preferably, in the LED arrangement structure, the plurality of adjacent second LEDs in each of the one or more second LED rows are sequentially arranged in the second direction to constitute the one light-emitting pixel.

More preferably, in the LED arrangement structure, each of a plurality of light-emitting pixels comprises a red LED, a blue LED, and a green LED.

More preferably, in the LED arrangement structure, each of the plurality of light-emitting pixels is the same.

Preferably, in the LED arrangement structure, the first LEDs and the second LEDs in each of the plurality of third LED rows are LEDs with the same light-emitting color.

Preferably, in the LED arrangement structure, each of the first LEDs is an LED with the same size.

Preferably, in the LED arrangement structure, each of the second LEDs is an LED with the same size.

Preferably, in the LED arrangement structure, each of the plurality of first LEDs is any one of a red LED, a blue LED, and a green LED.

Preferably, in the LED arrangement structure, each of the plurality of second LEDs is any one of a red LED, a blue LED, and a green LED.

Preferably, in the LED arrangement structure, non-common-electrode terminals of a first LED and a second LED adjacent to the first LED in each of the plurality of third LED rows are electrically connected to each other on a surface layer of the PCB board.

Preferably, in the LED arrangement structure, non-common-electrode terminals of the first LEDs in each of the plurality of third LED rows are electrically connected to each other through via holes on the PCB board.

Preferably, in the LED arrangement structure, non-common-electrode terminals of the second LEDs in each of the plurality of third LED rows are electrically connected to each other through via holes on the PCB board.

Preferably, in the LED arrangement structure, non-common-electrode terminals of the first LEDs and a part of the second LEDs in each of the plurality of third LED rows are electrically connected to each other through via holes on the PCB board.

Preferably, in the LED arrangement structure, the first LEDs and the second LEDs are encapsulated on the PCB board in a COB manner or an SMD manner.

### Beneficial effect

An LED arrangement structure is provided by an embodiment of the present invention. A plurality of first LEDs and a plurality of second LEDs are disposed on the PCB board, the first LEDs and the second LEDs are arrayed in a first direction and a second direction, the plurality of first LEDs form one or more first LED rows in the second direction, the plurality of second LEDs form one or more second LED rows in the second direction, the plurality of first LEDs and the plurality of second LEDs form a plurality of third LED rows in the first direction. In addition, common-electrode terminals of the first LEDs in each first LED row are electrically connected to form one scanning line, common-electrode terminals of the second LEDs in each second LED row are electrically connected to form one scanning line, and non-common-electrode terminals of the first LEDs and the second LEDs in each third LED row are electrically connected to form one data line. The common-electrode or non-common-electrode terminals of a first LED and a second LED adjacent to each other in each third LED row are adjacent to each other, and the scanning line and the data line are located on different layers of the PCB board. Therefore, not only the number of via holes on the PCB board can be reduced, but also the width or the number of layers of the PCB board does not need to be additionally increased, and the yield of the PCB board is improved while the production cost of the LED display screen is reduced.

### BRIEF DESCRIPTION OF THE DRAWINGS

In order to more clearly explain the technical solutions in the embodiments of the present disclosure, the following will briefly introduce the drawings required in the description of the embodiments. Obviously, the drawings in the following description are only some embodiments which are not all part of the invention. For those skilled in the art, without paying any creative work, other drawings can be obtained based on these drawings.
FIG. 1 is a schematic diagram of an LED arrangement structure in the prior art;
FIG. 2 is another schematic diagram of an LED arrangement structure in the prior art;
FIG. 3 is a schematic diagram of an LED arrangement structure according to an embodiment which is not part of the invention;
FIG. 4 is a schematic diagram of an LED arrangement structure according to another embodiment of the present invention;
FIG. 5 is a schematic diagram of an LED arrangement structure according to another embodiment of the present invention;
FIG. 6 is a schematic diagram of an LED arrangement structure according to another embodiment which is not part of the invention; and
FIG. 7 is a schematic diagram of an LED arrangement structure according to another embodiment which is not part of the invention.

### DETAILED DESCRIPTION

In the description of the present disclosure, it should be understood that orientations or position relationships indicated by the terms "center", "lateral", "upper", "lower", "left", "right", "vertical", "horizontal", "top", "bottom", "inside", "outside", "column," "row," and the like, are based on orientations or position relationships illustrated in the drawings. The terms are used to facilitate and simplify the description of the present disclosure, rather than indicate or imply that the devices or elements referred to herein are required to have specific orientations or be constructed or operate in the specific orientations. Accordingly, the terms should not be construed as limiting the present disclosure.

In the present disclosure, the word "some embodiments" is used to mean "serving as an example, illustration, or explanation". Any embodiment described as exemplary in the present disclosure is not necessarily construed as being more preferable or advantageous than other embodiments. In order to enable any person skilled in the art to implement and use the present disclosure, the following description is given. In the following description, the details are listed for the purpose of explanation. It should be understood that those of ordinary skill in the art can realize that the present disclosure can also be implemented without using these specific details. In other instances, well-known structures and processes will not be elaborated to avoid unnecessary details to obscure the description of the present disclosure. Therefore, the present disclosure is not intended to be limited to the illustrated embodiments, but is defined by the appended claims.

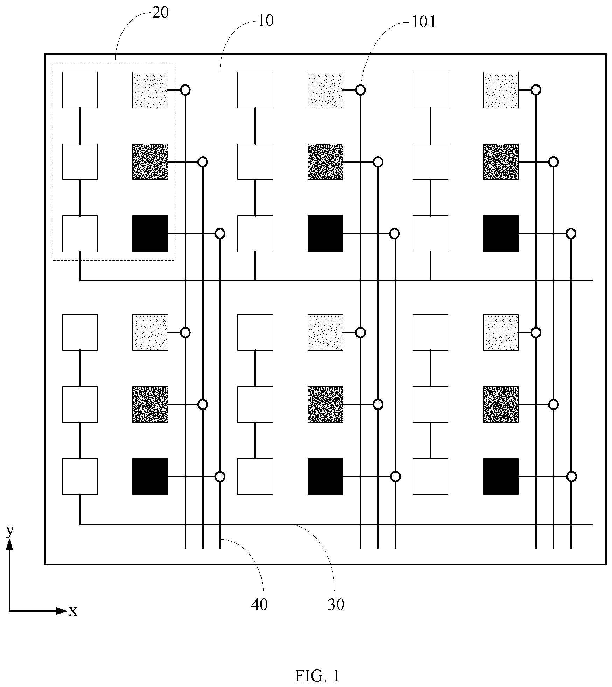

It should be noted that a first direction and a second direction mentioned in the embodiments of the present disclosure are perpendicular to each other, and the first direction may be a column direction or a row direction. Similarly, the second direction corresponds to the row direction or the column direction, and the first direction and the second direction may be interchanged in actual application. When the first direction is an x direction indicated in FIGS. 1 to 7, that is, each of a first LED row and a second LED row is a column of LEDs, the second direction is a y direction indicated in FIGS. 1 to 7, that is, the third LED row is a row of LEDs, the x direction in FIGS. 1 to 7 is a row direction, and the y direction is a column direction.

Referring to FIG. 1, there is shown a schematic diagram of an LED arrangement structure in the prior art. As shown in FIG. 1, a plurality of light-emitting pixels 20 with the same structure are arranged on a PCB board 10 in an array manner., and each of the light-emitting pixels 20 includes three LEDs of different light-emitting colors, such as, a red LED, a blue LED, and a green LED, so that both the LEDs and the light-emitting pixels 20 are arranged on the PCB board 10 in an array manner. Common-electrode terminals of all the LEDs in each row of the light-emitting pixels 20 are electrically connected on the surface layer of the PCB board 10 to form one row scanning line, and non-common-electrode terminals of the LEDs of the same light-emitting color in each column of the light-emitting pixels 20 are electrically connected at the inner or bottom layer of the PCB board 10 through via holes 101 on the PCB board 10 to form one column data line. Here, the strobe chip performs progressive scanning of the pixels on the PCB board 10 through scanning lines 30, and the driver chip applies different currents through data lines 40 to obtain different colors in various light-emitting pixels 20, thereby obtaining a complete image on the PCB board 10.

As can be seen from FIG. 1, the number of via holes 101 in the PCB board 10 is determined by the number of LEDs, and three via holes 101 are required for each light-emitting pixel 20 to enable the data lines 40 to be led to the inner or bottom layer of the PCB board 10.

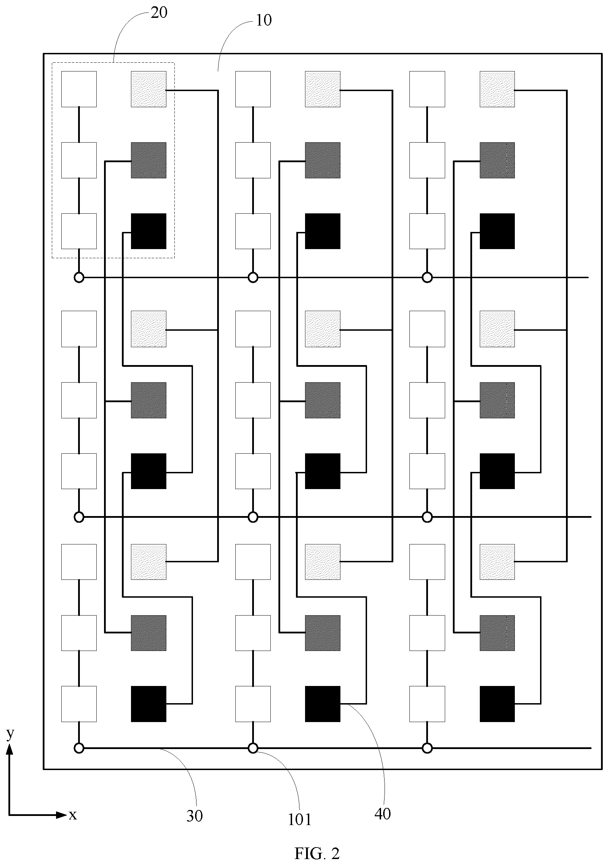

Referring to FIG. 2, FIG. 2 is a schematic diagram of another LED arrangement structure in the prior art. As shown in FIG. 2, a plurality of light-emitting pixels 20 of the same structure are arranged on a PCB board 10 in an array manner, and each of the light-emitting pixels 20 includes three LEDs of different light-emitting colors, such as, a red LED, a blue LED, and a green LED, so that both the LEDs and the light-emitting pixels 20 are arranged on the PCB board 10 in an array manner. Common-electrode terminals of all the LEDs in each row of light-emitting pixels 20 are electrically connected at the inner or bottom layer of the PCB board 10 through via holes 101 in the PCB board 10 to form one row scanning line, and non-common-electrode terminals of the LEDs of the same light-emitting color in each column of light-emitting pixels 20 are electrically connected on a surface layer of the PCB board 10 to form one column data line 40.

As can be seen from FIG. 2, in order to avoid the problem of intersection of the scanning line 30 and the data line 40, in each column of light-emitting pixels 20, two data lines 40 need to pass between the positive and negative electrodes of one or more LEDs. Although only one via hole 101 is required for each light-emitting pixel 20 in FIG. 2, due to the constraints of the wiring rules of the PCB board 10, the data line 40 passing between the positive and negative electrodes of the LEDs will inevitably cause the size of the LEDs to be increased, thereby causing a sharp increase in cost. As an example of the conventional COB chip 0408 (4 mil×8 mil), the distance between the positive and negative electrodes of the COB chip is only 75µm, and generally, the pad spacing on the PCB board 10 should be designed to be smaller than the pad spacing on the COB chip to prevent the occurrence of misalignment, so the value of the pad spacing on the PCB board 10 is generally 70µm. In accordance with the process level of the PCB board 10, the line width and the line spacing of the general wirings are both 100µm. If two data lines 40 both pass between the positive and negative electrodes of the COB chip, the distance between the positive and negative electrodes of the COB chip is at least 500µm. In this case, the COB chip must be much larger than the design size of the original 75µm of the diode, which will make the diode very large and cause the manufacturing cost to increase sharply.

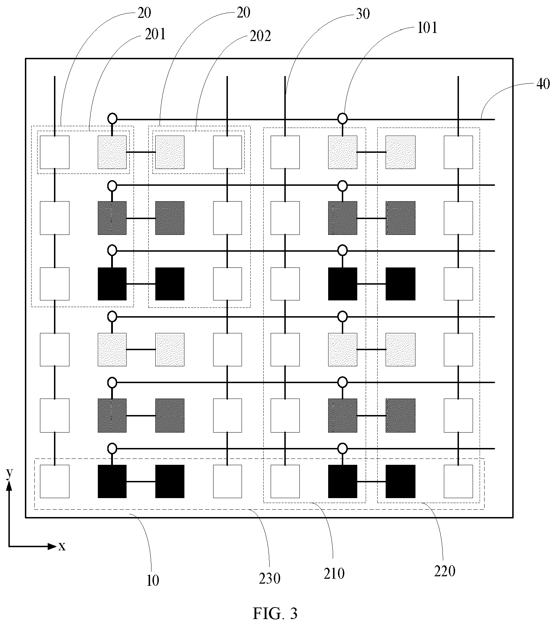

Referring to FIG. 3, there is shown a schematic diagram of an LED arrangement structure according to an embodiment which is not part of the invention. As shown in FIG. 3, an LED arrangement structure includes:
a PCB board 10;
a plurality of first LEDs 201 and a plurality of second LEDs 202 disposed on the PCB board 10; the first LEDs 201 and the second LEDs 202 are arranged in a first direction and a second direction in an array manner;
the plurality of first LEDs 201 form a plurality of first LED rows 210 along the second direction, the plurality of second LEDs 202 form a plurality of second LED rows 220 along the second direction, and some of the plurality of first LEDs 201 and some of the plurality of second LEDs 202 form a plurality of third LED row 230 in the first direction;
common-electrode terminals of respective first LEDs 201 in each of the first LED rows 210 are electrically connected to form one scanning line 30; common-electrode terminals of respective second LEDs 202 in each of the second LED rows 220 are electrically connected to form one scanning line 30; non-common-electrode terminals of each of the first LEDs 201 and each of the second LEDs 202 in each of the third LED rows 230 are electrically connected to form one data line 40;
common-electrode or non-common-electrode terminals of the first LED 201 and the second LED 202 adjacent to each other in each of the third LED rows 230 are adjacent to each other; the scanning lines 30 and the data lines 40 are located in different layers in the PCB board 10.

According to the LED arrangement structure provided in the embodiment which is not part of the invention, the plurality of first LEDs 201 and the plurality of second LEDs 202 are disposed on the PCB board 10, the first LEDs 201 and the second LEDs 202 are arranged in a first direction and a second direction in the array manner, the plurality of first LEDs 201 form the plurality of first LEDs rows 210 in the second direction, the plurality of second LEDs 202 form the plurality of second LED rows 220 in the second direction, and the plurality of first LEDs 201 and the plurality of second LEDs 202 form the plurality of third LED rows 230 in the first direction. At the same time, the common-electrode terminals of the first LEDs 201 in each of the first LED rows 210 are electrically connected to form one scanning line 30 in the second direction, the common-electrode terminals of the second LEDs 202 in each of the second LED rows 220 are electrically connected to form one scanning line 30 in the second direction, and the non-common-electrode terminals of the second LEDs 202 and the first LEDs 201 in each of the third LED rows 230 are electrically connected to form one data line 40 in the first direction. The common-electrode terminals or non-common-electrode terminals of the first LED 201 and the second LED 202 adjacent to each other in each of the third LED rows 230 are adjacent to each other, and the scanning line 30 and the data line 40 are located in different layers in the PCB board 10, which may not only reduce the number of via holes 101 in the PCB board 10, but also do not need to increase the width or the number of layers of the PCB board 10 additionally, and reduce the production cost of the LED display screen while increasing the yield of the PCB board 10.

Specifically, in the embodiment shown in FIG. 3, three adjacent first LEDs 201 in the first LED row 210 may form one light-emitting pixel 20, and three adjacent second LEDs 202 in the second LED row 220 may form one light-emitting pixel 20. The first LEDs 201 in the light-emitting pixel 20 are vertically arranged, and the second LEDs 202 in the light-emitting pixel 20 are similarly vertically arranged. The scanning line 30 formed by electrically connecting the common-electrode terminals of the first LEDs 201 in each of the first LED rows 210 is a column scanning line, the scanning line 30 formed by electrically connecting the common-electrode terminals of the second LEDs 202 in each of the second LED rows 220 is also a column scanning line, and the date line 40 formed by electrically connecting the non-common-electrode terminals of the first LEDs 201 and the second LEDs 202 in each of the third LED rows 230 is a row data line. Since the common-electrode terminals or the non-common-electrode terminals of the first LED 201 and the second LED 202 adjacent to each other in each of the third LED rows 230 are adjacent to each other, the LEDs in at least the first LED rows 210 or the second LED rows 220 may not be provided with the via holes 101 in the PCB board 10, and each of the LEDs is not required to be provided with a via hole 101 in the PCB board 10. Therefore, the number of the via holes 101 in the PCB board 10 is reduced without increasing the size of the LED and the width or thickness of the PCB board 10, thereby reducing the production cost of the LED display screen while improving the yield of the PCB board 10.

In some embodiments, each of the scanning lines 30 is disposed on the surface layer of the PCB board 10, and each of the data lines 40 is disposed on the bottom or inner layer of the PCB board 10. Specifically, the scanning line 30 formed by electrically connecting the common-electrode terminals of the first LEDs 201 in each of the first LED rows 210 is disposed on the surface layer of the PCB board 10, the scanning line 30 formed by electrically connecting the common-electrode terminals of the second LEDs 202 in each of the second LED rows 220 is also disposed on the surface layer of the PCB BOARD 10, and the data line 40 formed by electrically connecting the non-common-electrode terminals of the first LEDs 201 and the second LEDs 202 in each of the third LED rows 230 is disposed on the bottom layer or the inner layer of the PCB board 10.

In some embodiments, several adjacent first LEDs 201 in each of the first LED rows 210 constitute one light-emitting pixel 20, and several adjacent second LEDs 202 in each of the second LED rows 220 constitute one light-emitting pixel 20. Specifically, one light-emitting pixel 20 may be formed by a plurality of LEDs, one or more LEDs having the same or different light-emitting colors may be present in the one light-emitting pixel 20, the two light-emitting pixels 20 may or may not be completely the same in terms of the size, number, and color of the LEDs, and a specific arrangement thereof may be configured according to an actual application.

In some embodiments, the first LEDs 201 and the second LEDs 202 in each of the third LED rows 230 are LEDs of the same light-emitting color; the first LED 201 and the second LED 202 are LEDs of the same size; the first LED 201 and the second LED 202 are any one of red LEDs, blue LEDs, and green LEDs.

Specifically, in the present embodiment, all light-emitting pixels 20 are identical to each other, and each of the light-emitting pixels 20 is composed of a red LED, a blue LED, and a green LED. The red LED, the blue LED, and the green LED are vertically arranged from top to bottom in the second direction in sequence, so that the left and right viewing angles of the LED display screens are symmetrical, and the left and right viewing angles of the LED display screens formed into a finished product are maximized.

Specifically, each of the light-emitting pixels 20 may be composed of the red LED, the blue LED, and the green LED. Similarly, the light-emitting pixels 20 formed on the PCB board 10 by the first LEDs 201 and the second LEDs 202 are arranged on the PCB board 10 in the array manner. The red LED, the blue LED, and the green LED in each of the light-emitting pixels 20 may be vertically arranged from top to bottom in sequence.

It should be noted that the first LEDs 201 and the second LEDs 202 in each of the third LED row 230 may be LEDs of the same size, or may be LEDs of different sizes, as long as the left and right positions of the common-electrode and non-common-electrode terminals of the second LED 202 in the first LED row 210 and the second LED row 220 that are adjacent to each other are reversed as shown in FIG. 3, so that the via holes 101 in at least one column on the PCB board 10 may be omitted.

In some embodiments, the non-common-electrode terminals of the first LED 201 and the second LED 202 that are adjacent to each other in each of the third LED rows 230 are electrically connected at the surface layer of the PCB board 10. Specifically, when the common-electrode terminals of the first LED 201 and second LED 202 that are adjacent to each other in each of the third LED rows 230 are adjacent to each other, if there is only one corresponding first LED row 210 on the PCB board 10, the first LED row 210 cannot be placed at the outermost edge of the array and needs to be arranged in the middle of the array; if there is only one corresponding second LED row 220 on the PCB board 10, the second LED row 220 cannot be placed at the outermost edge of the array and needs to be arranged in the middle of the array. In this case, the electrical connection between the non-common-electrode terminals of the first LED 201 and the second LED 202 that are adjacent to each other in the third LED row 230 on the surface layer of the PCB board 10 can be realized, thereby reducing the number of via holes 101 on the PCB board 10. When the non-common-electrode terminals of the first LED 201 and second LED 202 that are adjacent to each other in each of the third LED rows 230 are adjacent to each other, the electrical connection between the non-common-electrode terminals of the first LED 201 and second LED 202 that are adjacent to each other in the third LED row 230 can be directly realized on the surface layer of the PCB board 10, thereby reducing the number of via holes 101 on the PCB board 10.

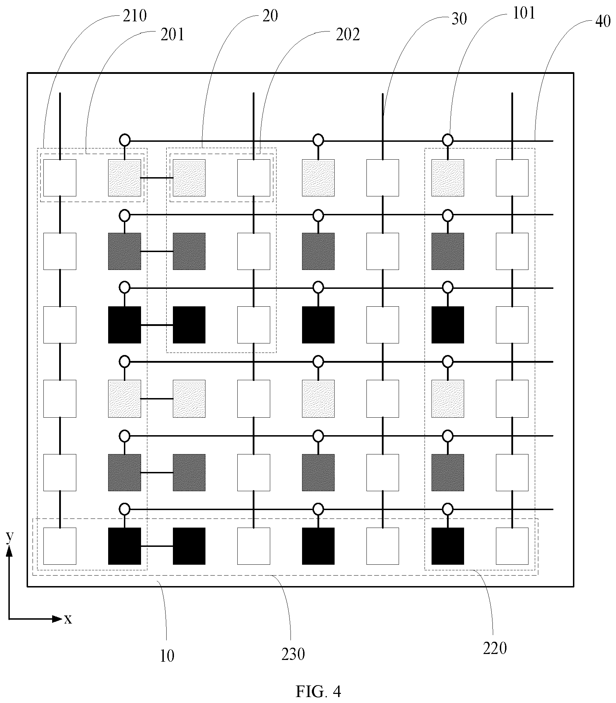

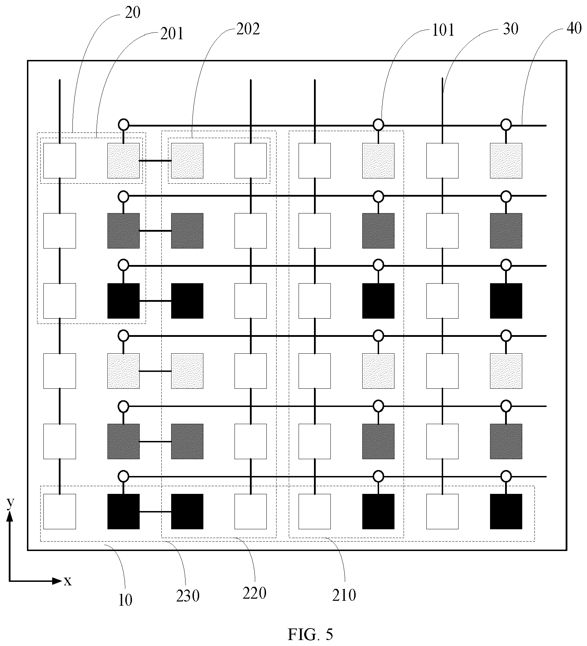

In some embodiments, as shown in FIGS. 3 to 5, the number of the first LED rows 210 and the number of the second LED rows 220 on the PCB board 10 may or may not be equal, the first LED rows 210 and the second LED rows 220 may or may not be arranged alternately on the PCB board 10, and the number of via holes 101 on the PCB board 10 may be reduced only if the common-electrode or non-common-electrode terminals of the first LED 201 and second LED 202 that are adjacent to each other in each of the third LED rows 230 are adjacent to each other. In Fig.3 which illustrates an embodiment which is not part of the invention, the number of the first LED rows 210 is equal to the number of the second LED rows 220, and the first LED rows 210 and the second LED rows 220 are alternately arranged on the PCB board 10, so that half of the via holes 101 on the PCB board 10 can be omitted with respect to FIG. 1. The number of the first LED rows 210 in FIG. 4 which illustrates an embodiment which is part of the invention, is less than the number of the second LED rows 220. If the number of the first LED rows 210 is a and the number of the second LED rows 220 is b, the via holes 101 of the a rows can be omitted from the PCB board 10 in FIG. 1. In FIG. 5, which illustrates an embodiment which is part of the invention, the number of the first LED rows 210 is greater than the number of the second LED rows 220. If the number of the first LED rows 210 is a and the number of the second LED rows 220 is b, the via holes 101 of the b rows may be omitted from the PCB board 10 in FIG. 1.

In some embodiments not part of the invention, the non-common-electrode terminals of all the first LEDs 201 in each of the third LED rows 230 are electrically connected to each other through via holes 101 on the PCB board 10. Specifically, as shown in FIG. 3, when the non-common-electrode terminals of all the first LEDs 201 in the third LED row 230 are electrically connected to each other through the via holes 101 on the PCB board 10, it is only necessary to electrically connect the non-common-electrode terminal of the second LED 202 adjacent to the first LED 201 with the non-common-electrode terminal of the first LED 201 on the surface layer of the PCB board 10, so as to reduce the number of the via holes 101 on the PCB board 10.

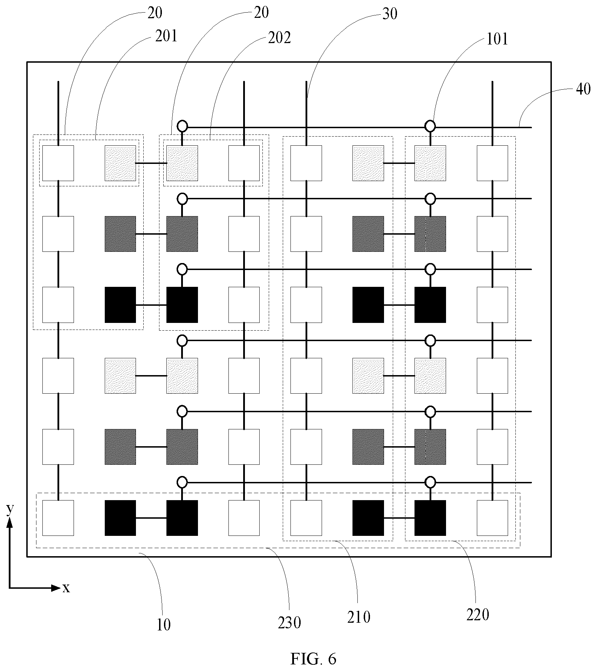

In some embodiments not part of the invention, the non-common-electrode terminals of all the second LEDs 202 in each of the third LED rows 230 are electrically connected to each other through via holes 101 on the PCB board 10. Specifically, as shown in FIG. 6, when non-common-electrode terminals of all second LEDs 202 in a third LED row 230 are electrically connected to each other through the via holes 101 on the PCB board 10, it is only necessary to electrically connect a non-common-electrode terminal of a first LED 201 adjacent to a second LED 202 with a non-common-electrode terminal of the second LED 202 on the surface layer of the PCB board 10, so as to reduce the number of the via holes 101 in the PCB board 10.

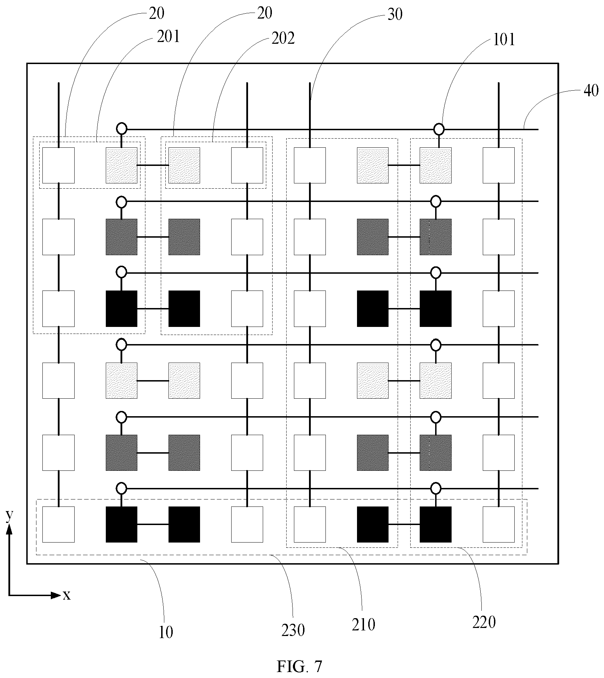

In some embodiments not part of the invention, the non-common-electrode terminals of the first LED 201 and the second LED 202 in each of the third LED rows 230 are electrically connected to each other through the via hole 101 on the PCB board 10. Specifically, as shown in FIG. 7, when non-common-electrode terminals of a first LED 201 and a second LED 202 in a third LED row 230 are electrically connected to each other through a via hole 101 on the PCB board 10, a non-common-electrode terminal of a second LED 202 adjacent to the first LED 201 is electrically connected to the non-common-electrode terminal of the first LED 201 on the surface layer of the PCB board 10, and a non-common-electrode terminal of a first LED 201 adjacent to the second LED 202 is electrically connected to the non-common-electrode terminal of the second LED 202 on the surface layer of the PCB board 10, thereby reducing the number of via holes 101 on the PCB board 10.

It may be appreciated that one first LED 201 in the third LED row 230 corresponds to a single first LED row 210, and one second LED 202 corresponds to a single second LED row 220. The first LED rows 210 and the second LED rows 220 are arranged in the first direction, and the third LED rows 230 are arranged in the second direction.

It may also be appreciated that the arrangement of the LEDs in FIGS. 3 to 7 may be rotated by 90 degrees in practical applications, i.e., the column scanning lines formed in FIGS. 3 to 7 become row scanning lines, the row data lines become column data lines, and the LEDs in each of the light-emitting pixels 20 are arranged horizontally.

It may also be appreciated that the LEDs 201 in the LED lamp panel structure provided in the embodiments of the present disclosure may be packaged on the PCB board 10 in a COB (Chip On Board) manner, or may be packaged on the PCB board 10 in an SMD (Surface Mounted Devices) manner, which may be selected according to the specific situation in the actual application, and is not specifically limited in the present disclosure.

In the specific implementation, each of the above units or structures may be implemented as a separate object, or may be implemented in any combination as the same object or several objects. For a specific implementation of each of the above units or structures, reference may be made to the foregoing embodiments, and details are not described herein.

The LED arrangement according to an embodiment of the present disclosure have been described in detail. The principles and embodiments of the present disclosure have been described with reference to specific embodiments, and the description of the above embodiments is merely intended to aid in the understanding of the method of the present disclosure and its core idea.

## Claims

1. An LED arrangement structure, comprising:
a PCB board (10); and
a plurality of first LEDs (201) and a plurality of second LEDs (202) disposed on the PCB board (10), the plurality of first LEDs (201) and the plurality of second LEDs (202) being arranged in a first direction (x) and/or a second direction (y) in an array manner,
wherein the plurality of first LEDs (201) form one or more first LED rows (210) in the second direction (y), the plurality of second LEDs (202) form one or more second LED rows (220) in the second direction (y), and the plurality of first LEDs (201) and the plurality of second LEDs (202) form a plurality of third LED rows (230) in the first direction (x);
common-electrode terminals of first LEDs (201) in each of the one or more first LED rows (210) are electrically connected to each other to form one scanning line (30);
common-electrode terminals of second LEDs (202) in each of the one or more second LED rows (220) are electrically connected to each other to form one scanning line (30);
**characterized in that**,
each one of the third LED rows (230) comprises one first LED (201) and a plurality of second LEDs (202), a side of the common-electrode terminal of the one first LED (201) is not adjacent to any of the plurality of second LEDs (202), and a side of the non-common-electrode terminal of the one first LED (201) is adjacent to one of the plurality of second LEDs (202), the non-common-electrode terminals of the one first LED (201) and the plurality of second LEDs (202) are electrically connected to each other to form one data line (40), the scanning lines (30) and the data lines (40) are disposed on different layers in the PCB board (10), and the plurality of second LEDs (202) are adjacent to each other; or
each one of the third LED rows (230) comprises a plurality of first LEDs (201) and one second LED (202), the side of the common-electrode terminal of one of the plurality of first LEDs (201) is not adjacent to the one second LED (202) and any of the remaining first LEDs (201), and a side of the non-common-electrode terminal of the one of the plurality of first LEDs (201) is adjacent to the one second LED (202), the non-common-electrode terminals of the plurality of first LEDs (201) and the one second LED (202) are electrically connected to each other to form one data line (40), the scanning lines (30) and the data lines (40) are disposed on different layers in the PCB board (10), and the remaining first LEDs (201) except for the one of the plurality of first LEDs (201) are adjacent to each other.

2. The LED arrangement structure according to claim 1, wherein each of the scanning lines (30) is disposed on a surface layer of the PCB board (10), and each of the data lines (40) is disposed on a bottom layer or an inner layer of the PCB board (10).

3. The LED arrangement structure according to claim 1, wherein a plurality of adjacent first LEDs (201) in each of the one or more first LED rows (210) constitute one light-emitting pixel (20).

4. The LED arrangement structure according to claim 3, wherein the plurality of adjacent first LEDs (201) in each of the one or more first LED rows (210) are sequentially arranged in the second direction (y) to constitute the one light-emitting pixel (20).

5. The LED arrangement structure according to claim 1, wherein a plurality of adjacent second LEDs (202) in each of the one or more second LED rows (220) constitute one light-emitting pixel (20).

6. The LED arrangement structure according to claim 5, wherein the plurality of adjacent second LEDs (202) in each of the one or more second LED rows (220) are sequentially arranged in the second direction (y) to constitute the one light-emitting pixel (20).

7. The LED arrangement structure according to claim 3 or 5, wherein each of a plurality of light-emitting pixels (20) comprises a red LED, a blue LED, and a green LED.

8. The LED arrangement structure according to claim 1, wherein the first LEDs (201) and the second LEDs (202) in each of the plurality of third LED rows (230) are LEDs with the same light-emitting color.

9. The LED arrangement structure according to claim 1, wherein each of the first LEDs (201) is an LED with the same size, and/or each of the second LEDs (202) is an LED with the same size.

10. The LED arrangement structure according to claim 1, wherein each of the plurality of first LEDs (201) is any one of a red LED, a blue LED, and a green LED, and/or each of the plurality of second LEDs (202) is any one of a red LED, a blue LED, and a green LED.

11. The LED arrangement structure according to claim 1, wherein non-common-electrode terminals of a first LED (201) and a second LED (202) adjacent to the first LED (201) in each of the plurality of third LED rows (230) are electrically connected to each other on a surface layer of the PCB board (10).

12. The LED arrangement structure according to claim 1, wherein non-common-electrode terminals of the first LEDs (201) in each of the plurality of third LED rows (230) are electrically connected to each other through via holes (101) on the PCB board (10).

13. The LED arrangement structure according to claim 1, wherein non-common-electrode terminals of the second LEDs (202) in each of the plurality of third LED rows (230) are electrically connected to each other through via holes (101) on the PCB board (10).

14. The LED arrangement structure according to claim 1, wherein non-common-electrode terminals of the first LEDs (201) and a part of the second LEDs (202) in each of the plurality of third LED rows (230) are electrically connected to each other through via holes (101) on the PCB board (10).

## Patentansprüche

1. LED-Anordnungsstruktur, umfassend:
eine Leiterplatte (10); und
eine Vielzahl von ersten LEDs (201) und eine Vielzahl von zweiten LEDs (202), die auf der Leiterplatte (10) angeordnet sind, wobei die Vielzahl von ersten LEDs (201) und die Vielzahl von zweiten LEDs (202) in einer ersten Richtung (x) und/oder einer zweiten Richtung (y) in einem Array angeordnet sind,
wobei die Vielzahl von ersten LEDs (201) eine oder mehrere erste LED-Reihen (210) in der zweiten Richtung (y) bildet, die Vielzahl von zweiten LEDs (202) eine oder mehrere zweite LED-Reihen (220) in der zweiten Richtung (y) bildet, und die Vielzahl von ersten LEDs (201) und die Vielzahl von zweiten LEDs (202) eine Vielzahl von dritten LED-Reihen (230) in der ersten Richtung (x) bilden;
gemeinsame Elektrodenanschlüsse von ersten LEDs (201) in jeder der einen oder mehreren ersten LED-Reihen (210) elektrisch miteinander verbunden sind, um eine Abtastleitung (30) zu bilden; gemeinsame Elektrodenanschlüsse von zweiten LEDs (202) in jeder der einen oder mehreren zweiten LED-Reihen (220) elektrisch miteinander verbunden sind, um eine Abtastleitung (30) zu bilden;
**dadurch gekennzeichnet,**
**dass** jede der dritten LED-Reihen (230) eine erste LED (201) und eine Vielzahl von zweiten LEDs (202) umfasst, wobei eine Seite des gemeinsamen Elektrodenanschluss der einen ersten LED (201) keiner der Vielzahl von zweiten LEDs (202) angrenzt, und eine Seite des nicht-gemeinsamen Elektrodenanschluss der einen ersten LED (201) einer der Vielzahl von zweiten LEDs (202) angrenzt, wobei nicht-gemeinsame Elektrodenanschlüsse der einen ersten LED (201) und die Vielzahl von zweiten LEDs (202) elektrisch miteinander verbunden sind, um eine Datenleitung (40) zu bilden, wobei die Abtastleitungen (30) und die Datenleitungen (40) auf verschiedenen Schichten in der Leiterplatte (10) angeordnet sind, und die Vielzahl von zweiten LEDs (202) aneinander angrenzen; oder
**dass** jede der dritten LED-Reihen (230) eine Vielzahl von ersten LEDs (201) und eine zweite LED (202) umfasst, wobei die Seite des gemeinsamen Elektrodenanschluss einer der Vielzahl von ersten LEDs (201) keiner einen zweiten LED (202) und keiner einen der übrigen ersten LEDs (201) angrenzt, und eine Seite des gemeinsamen Elektrodenanschluss der einen der Vielzahl von ersten LEDs (201) der einen zweiten LED (202) angrenzt, wobei nicht-gemeinsame Elektrodenanschlüsse der Vielzahl von ersten LEDs (201) und die eine zweite LED (202) elektrisch miteinander verbunden sind, um eine Datenleitung (40) zu bilden, wobei die Abtastleitungen (30) und die Datenleitungen (40) auf verschiedenen Schichten in der Leiterplatte (10) angeordnet sind, und die übrigen ersten LEDs (201) mit Ausnahme einer der Vielzahl von ersten LEDs (201) aneinander angrenzen.

2. LED-Anordnungsstruktur nach Anspruch 1, wobei jede der Abtastleitungen (30) auf einer Oberflächenschicht der Leiterplatte (10) angeordnet ist, und jede der Datenleitungen (40) auf einer Bodenschicht oder einer Innenschicht der Leiterplatte (10) angeordnet ist.

3. LED-Anordnungsstruktur nach Anspruch 1, wobei eine Vielzahl von angrenzenden ersten LEDs (201) in jeder der einen oder mehreren ersten LED-Reihen (210) ein lichtemittierendes Pixel (20) bildet.

4. LED-Anordnungsstruktur nach Anspruch 3, wobei die Vielzahl von angrenzenden ersten LEDs (201) in jeder der einen oder mehreren ersten LED-Reihen (210) in der zweiten Richtung (y) nacheinander angeordnet sind, um das eine lichtemittierende Pixel (20) zu bilden.

5. LED-Anordnungsstruktur nach Anspruch 1, wobei eine Vielzahl von angrenzenden zweiten LEDs (202) in jeder der einen oder mehreren zweiten LED-Reihen (220) ein lichtemittierendes Pixel (20) bildet.

6. LED-Anordnungsstruktur nach Anspruch 5, wobei die Vielzahl von angrenzenden zweiten LEDs (202) in jeder der einen oder mehreren zweiten LED-Reihen (220) in der zweiten Richtung (y) nacheinander angeordnet sind, um das eine lichtemittierende Pixel (20) zu bilden.

7. LED-Anordnungsstruktur nach Anspruch 3 oder 5, wobei jedes der Vielzahl von lichtemittierenden Pixeln (20) eine rote LED, eine blaue LED und eine grüne LED umfasst.

8. LED-Anordnungsstruktur nach Anspruch 1, wobei die ersten LEDs (201) und die zweiten LEDs (202) in jeder der Vielzahl von dritten LED-Reihen (230) LEDs mit derselben lichtemittierenden Farbe sind.

9. LED-Anordnungsstruktur nach Anspruch 1, wobei jede der ersten LEDs (201) eine LED mit der gleichen Größe ist und/oder jede der zweiten LEDs (202) eine LED mit der gleichen Größe ist.

10. LED-Anordnungsstruktur nach Anspruch 1, wobei jede der Vielzahl von ersten LEDs (201) eine beliebige von einer roten LED, einer blauen LED und einer grünen LED ist und/oder jede der Vielzahl von zweiten LEDs (202) eine beliebige von einer roten LED, einer blauen LED und einer grünen LED ist.

11. LED-Anordnungsstruktur nach Anspruch 1, wobei nicht-gemeinsame Elektrodenanschlüsse einer ersten LED (201) und einer zweiten LED (202), die der ersten LED (201) angrenzt, in jeder der Vielzahl von dritten LED-Reihen (230) auf einer Oberflächenschicht der Leiterplatte (10) elektrisch miteinander verbunden sind.

12. LED-Anordnungsstruktur nach Anspruch 1, wobei nicht-gemeinsame Elektrodenanschlüsse der ersten LEDs (201) in jeder der Vielzahl von dritten LED-Reihen (230) über Durchkontaktierungen (101) auf der Leiterplatte (10) elektrisch miteinander verbunden sind.

13. LED-Anordnungsstruktur nach Anspruche 1, wobei nicht-gemeinsame Elektrodenanschlüsse der zweiten LEDs (202) in jeder der Vielzahl von dritten LED-Reihen (230) ü ber Durchkontaktierungen (101) auf der Leiterplatte (10) elektrisch miteinander verbunden sind.

14. LED-Anordnungsstruktur nach Anspruch 1, wobei nicht-gemeinsame Elektrodenanschlüsse der ersten LEDs (201) und ein Teil der zweiten LEDs (202) in jeder der Vielzahl von dritten LED-Reihen (230) über Durchkontaktierungen (101) auf der Leiterplatte (10) elektrisch miteinander verbunden sind.

## Revendications

1. Structure d'agencement de DEL, comprenant :
une carte de circuit imprimé (10) ; et
une pluralité de premières DELs (201) et une pluralité de deuxièmes DELs (202) placées sur la carte de circuit imprimé (10), la pluralité de premières DELs (201) et la pluralité de deuxièmes DELs (202) étant agencées dans une première direction (x) et/ou une deuxième direction (y) en réseau,
dans laquelle la pluralité de premières DELs (201) forme une ou plusieurs rangées de DELs (210) dans la deuxième direction (y), la pluralité de deuxièmes DELs (202) forme une ou plusieurs rangées de DELs (220) dans la deuxième direction (y), et la pluralité de premières DELs (201) et la pluralité de deuxièmes DELs (202) forme une pluralité de troisièmes rangées de DELs (230) dans la première direction (x) ;
les bornes d'électrodes communes des premières DELs (201) dans chacune des unes ou plusieurs premières rangées de DELs (210) sont mutuellement raccordées électriquement pour former une ligne de balayage (30) ;
les bornes d'électrodes communes des deuxièmes DELs (202) dans chacune des unes ou plusieurs deuxièmes rangées de DELs (220) sont mutuellement raccordées électriquement pour former une ligne de balayage (30) ;
**caractérisée en ce que**,
chacune des troisièmes rangées de DELs (230) comprend une première DEL (201) et une pluralité de deuxièmes DELs (202), un côté des bornes d'électrodes communes de la première DEL (201) n'est pas adjacent à l'une quelconque de la pluralité de deuxièmes DELs (202), et un côté des bornes d'électrodes non-communes de la première DEL (201) est adjacent à l'une de la pluralité de deuxièmes DELs (202), les bornes d'électrodes non-communes de la première DEL (201) et la pluralité de deuxièmes DELs (202) sont mutuellement raccordées électriquement pour former une ligne de données (40), les lignes de balayage (30) et les lignes de données (40) sont placées sur différentes couches sur la carte de circuit imprimé (10), et la pluralité de deuxièmes DELs (202) sont mutuellement adjacentes ; ou
chacune des troisièmes rangées de DEL (230) comprend une pluralité de premières DELs (201) et une deuxième DEL (202), le côté de la borne d'électrode commune de l'une de la pluralité de premières DELs (201) n'est pas adjacent à la deuxième DEL (202) et à l'une quelconque des premières DELs (201) restantes, et un côté de la borne d'électrode commune de l'une de la pluralité de premières DELs (201) est adjacent à la deuxième DEL (202), laborne d'électrode commune de la pluralité de premières DELs (201) et la deuxième DEL (202) sont mutuellement raccordées électriquement pour former une ligne de données (40), les lignes de balayage (30) et les lignes de données (40) sont placées sur différentes couches sur la carte de circuit imprimé (10), et les premières DELs (201) restantes à l'exception de celle de la pluralité des premières DELs (201) sont mutuellement adjacentes.

2. Structure d'agencement de DEL selon la revendication 1, dans laquelle chaque ligne de balayage (30) est placée sur une couche de surface de la carte de circuit imprimé (10), et chacune des lignes de données (40) est placée sur la couche de base ou sur une couche interne de la carte de circuit imprimé (10).

3. Structure d'agencement de DEL selon la revendication 1, dans laquelle une pluralité de premières DELs (201) adjacentes dans chacune des une ou plusieurs premières rangées de DEL (210) constitue un pixel électroluminescent (20).

4. Structure d'agencement de DEL selon la revendication 3, dans laquelle la pluralité de premières DELs (201) adjacentes dans chacune des une ou plusieurs premières rangées de DEL (210) sont agencées de façon séquentielle dans la deuxième direction (y) pour constituer le pixel électroluminescent (20).

5. Structure d'agencement de DEL selon la revendication 1, dans laquelle une pluralité de deuxièmes DELs (202) adjacentes dans chacune des une ou plusieurs deuxièmes rangées de DEL (220) constitue un pixel électroluminescent (20).

6. Structure d'agencement de DEL selon la revendication 5, dans laquelle la pluralité de deuxièmes DELs (202) adjacentes dans chacune des une ou plusieurs deuxièmes rangées de DEL (220) sont agencées de façon séquentielle dans la deuxième direction (y) pour constituer le pixel électroluminescent (20).

7. Structure d'agencement de DEL selon la revendication 3 ou 5, dans laquelle chacune de la pluralité de pixels électroluminescents (20) comprend une DEL rouge, une DEL bleue, et une DEL verte.

8. Structure d'agencement de DEL selon la revendication 1, dans laquelle les premières DELs (201) et les deuxièmes DELs (202) dans chacune de la pluralité de troisièmes rangées de DELs (230) sont des DELs de même couleur électroluminescente.

9. Structure d'agencement de DEL selon la revendication 1, dans laquelle chacune des premières DELs (201) est une DEL de même taille, et/ou chacune des deuxièmes DELs (202) est une DEL de même taille.

10. Structure d'agencement de DEL selon la revendication 1, dans laquelle chacune de la pluralité des premières DELs (201) est l'une quelconque parmi une DEL roue, une DEL bleue et une DEL verte, et/ou chacune de la pluralité des deuxièmes DELs (202) est l'une quelconque parmi une DEL roue, une DEL bleue et une DEL verte.

11. Structure d'agencement de DEL selon la revendication 1, dans laquelle les bornes d'électrodes non-communes d'une première DEL (201) et d'une deuxième DEL (202) adjacente à la première DEL (201) dans chacune de la pluralité de troisièmes rangées de DELs (230) sont mutuellement raccordées électriquement sur une couche de surface de la carte de circuit imprimé (10).

12. Structure d'agencement de DEL selon la revendication 1, dans laquelle les bornes d'électrodes non-communes des premières DELs (201) dans chacune de la pluralité de troisièmes rangées de DELs (230) sont mutuellement raccordées électriquement via des trous traversants (101) sur la carte de circuit imprimé (10).

13. Structure d'agencement de DEL selon la revendication 1, dans laquelle les bornes d'électrodes non-communes des deuxièmes DELs (202) dans chacune de la pluralité de troisièmes rangées de DELs (230) sont mutuellement raccordées électriquement via des trous traversants (101) sur la carte de circuit imprimé (10).

14. Structure d'agencement de DEL selon la revendication 1, dans laquelle les bornes d'électrodes non-communes des premières DELs (201) et une partie des deuxièmes DELs (202) dans chacune de la pluralité de troisièmes rangées de DELs (230) sont mutuellement raccordées électriquement via des trous traversants (101) sur la carte de circuit imprimé (10).
